# EUROPEAN PATENT APPLICATION

(11) **EP 1 217 646 A1**
(43) Date of publication of application: **26.06.2002**
(21) Application number: 00128434.8
(22) Date of filing: 22.12.2000
(51) Int. Cl.: H01L 21/00

(54) **Semiconductor product container and equipment for handling a semiconductor product container**

(71) Applicant: Semiconductor300 GmbH & Co KG, 01074 Dresden (DE)
(72) Inventor: Kuebart, Gregor, 01279 Dresden (DE)
(74) Representative: Fischer, Volker, Dipl.-Ing.

(57) **Abstract**

Disclosed is an equipment for handling a semiconductor product container (2), the equipment comprising handling means (14) for transporting and positioning the container, wherein a loading/unloading position requires first support members forming part of a loading/unloading device engaging with second support members forming part of the container. According to the invention, the equipment comprises detection means (15) for detecting reference point positions of the container and localization means (16) for computing the position of the container from the detected reference point positions, and allows for handling the containers without the need of mounting any support pins on each storage location in prior art.

## Description

The present invention refers to a container for the storage and/or the transport of at least one semiconductor product, the container comprising a housing with support region supporting the housing when standing on an essentially even ground, a load/unload region for loading and/or unloading the semiconductor product and a cover region enclosing the semiconductor product from at least two directions, wherein the housing comprises second support members positioned at predefined positions of the housing and engageable with first support members forming part of the semiconductor product loading/unloading device.

The invention further refers to an equipment for handling a semiconductor product container, the equipment comprising handling means for transporting the container between a loading/unloading position of a semiconductor product loading/unloading device and positions at other locations and for positioning in the container in the loading/unloading position, the loading/unloading position being such that first support members forming part of the loading/unloading device engage with second support members forming part of the container.

In semiconductor industry wafers are transported in front-opening unified pods (FOUPs) between loadports connected to different processing or measuring tools. The FOUPs are accommodating several wafers in a mini-environmental atmosphere of high purity. Once enclosed by the FOUP, the wafers can be transported within a cleanroom of less purity by operating personnel. The FOUP can be coupled with a loadport enclosing a mini-environmental atmosphere, too.

Semiconductor handling requires highly precise positioning of both the FOUP and the semiconductor wafers. Therefore, each loadport comprises three cinematic pins supporting the FOUP when coupled to the loadport. These pins engage in grooves allocated at the bottom side of the FOUP, thereby granting exact positioning of the FOUP on the loadport. Deviations from exact positioning may lead to semiconductor wafer destruction by handling means or to leakage of the outer cleanroom atmosphere into the mini-environmental atmosphere.

In order to grant highly precise positioning of the FOUPs, each other location intermediately supporting any FOUP comprises pins arranged in the same manner as the cinematic coupling pins of the loadports are arranged. These pins are allocated at predefined positions of all storage locations, thereby characterising predefined FOUP storage positions. Any equipment used for handling has a software storage for storing the predefined FOUP storage positions at the other locations.

This kind of handling is very disadvantageous and uncomfortable. First, each location - even a simple shelf serving as even support surface - has to be equipped with multitudes of support pins. Furthermore, any of such location is very restricted with view to possible FOUP positions thereon. Depending on geometry of the FOUPs and/or the storage locations, continuously variable FOUP storage positions may be desirable.

Second, any misalignment of the FOUP relative to the support pins may lead to inproper handling of the FOUP and, as a consequence, inproper positioning of the FOUP at the loadport. Hence, there is a risk of wafer destruction adherent to prior art FOUP handling systems.

It is the object of present invention to allow for proper semiconductor product container handling even in case of deviations of actual container positions at any other location relative to their predefined positions and/or in case of non-predefined container positions. Any actual container position shall allow for highly precise container positioning when it is transported to a container loading/unloading device like a loadport.

With view to the container, according to the invention the object is achieved by a container comprising marking elements marking reference points of the container, the reference points having predefined positions relative to the second support members.

With view to the equipment, the object of the invention is achieved by an equipment comprising detection means for detecting reference point positions of the container and localization means for computing the position of the container from the detected reference point positions, wherein the detection means and the localization means are controlling the equipment to position the container in the loading/unloading position if actual positions at the other locations are deviating from predefined positions stored by the equipment and/or if actual positions at the other locations are non-predefined with view to at least one direction or orientation.

The following idea is underlying the invention:

The essential portion of the FOUP granting its exact positioning at the loadport is its triple of grooves allocated beneath the bottom surface of the FOUP. Three cinematic coupling pins of any loadport engage in these grooves. However, when transporting the FOUP from or to the loadport, these grooves are not accessible by the handling means because they are facing the loadport table and are supported by the pins. Hence, according to prior art, the only way of detecting the actual position of the grooves and, as a consequence, of the FOUP, was to provide each other FOUP support location with copies of these triple of pins at predefined positions corresponding to predefined stepwise transport motion. In this way, proper support of FOUPs on any one of these triples of pins was necessary.

According to the present invention, marking elements allocated at those sides of the FOUP visible and/or accessible by the handling means are employed to indirectly define the position of the grooves of the FOUP.

According to the invention, these marking elements are marking reference points which have predefined positions relative to the grooves.

With view to the container according to the invention, the marking elements preferably are provided at at least two surfaces, more preferably at three surfaces of the container. Detecting positions of three marking elements allows for unequivocal definition of container position. However, depending on the geometry of other container support locations, less than three marking elements may be sufficient.

The marking elements are three-dimensional markings or, more preferably with view to posterior marking of existing containers, optical markings. In particular, the optical markings may be contrast markings comprising black and white or dark and bright regions of marking labels which may be attached to surfaces of FOUP comprising reference points.

Preferably, the optical markings are reflective. In any case, these markings may be produced as labels attachable to the housing of any existing FOUP. Thereby, any FOUP can be made capable of being transported according to the present invention.

Preferably, an optical marking is identifying one respective reference point in two dimensions. However, depending on the detection means for identifying reference point positions, even the location of a reference point perpendicular to the respective surface of the container may be identified.

Preferably, the container comprises further optical markings identifying one of a front-, side-, rear- or topside of the container. For instance, these additional markings may characterize each surface by a symbol or a certain number of unified symbols.

Preferably, the support members of the container for positioning it on a loading/unloading device are connected to the support region supporting the housing of the container when standing on an essentially even ground. More preferably, these support members are grooves allocated beneath the bottom side of the container. Most preferably, the container is a front-opening unified pod (FOUP).

The containers as described above may be handled by equipment according to the present invention. Detection means of the equipment detect reference point positions identified by the above marking elements, and localization means compute the position of the container from the detected reference point positions. By detecting reference point positions and localizing the container position, that is the position of its support members, the equipment is enabled to position the container in the loading/unloading position even in case that an actual position of the container supported at another location than a loading/unloading device deviates from a predefined position or in case that the actual position of the container on another location is non-predefined, that is variable, with view to at least one direction or orientation by reasons of geometry of the location. For instance, if containers are located on a shelf, the lateral position may be varied continuously and, in case of a shelf inclined laterally, may depend on the number of other containers already resting of the shelf.

Preferably, the detection means are attached to movable handling means. According to this embodiment, the handling means are enabled to define their position relative to the position of a container to be grabbed and transported to the loading/unloading device.

Preferably, the detection means comprise an optical camera which, of course, may be equipped with modern CCD-chips or other advanced digital imaging processing.

Preferably, a comparative position of the handling means relative to a position of the container is computed. With this comparative position, the handling means can be moved from this position to a predefined position relative to the container, the predefined position being suitable to grab the container for transporting it to the loading/unloading device and then positioning it on the cinematic coupling pins.

Preferably, the equipment is constructed to transport and position containers according to one of claims 1 - 13.

Hereinbelow, the invention is described with reference to the accompanying drawings.
- Figure 1: schematically illustrates a FOUP seen from front-right-top perspective view.
- Figures 2A - 2C: illustrate examples of marking elements.
- Figure 3: schematically illustrates the bottom side of a FOUP in detail.
- Figure 4: schematically illustrates the function of the equipment according to the present invention.

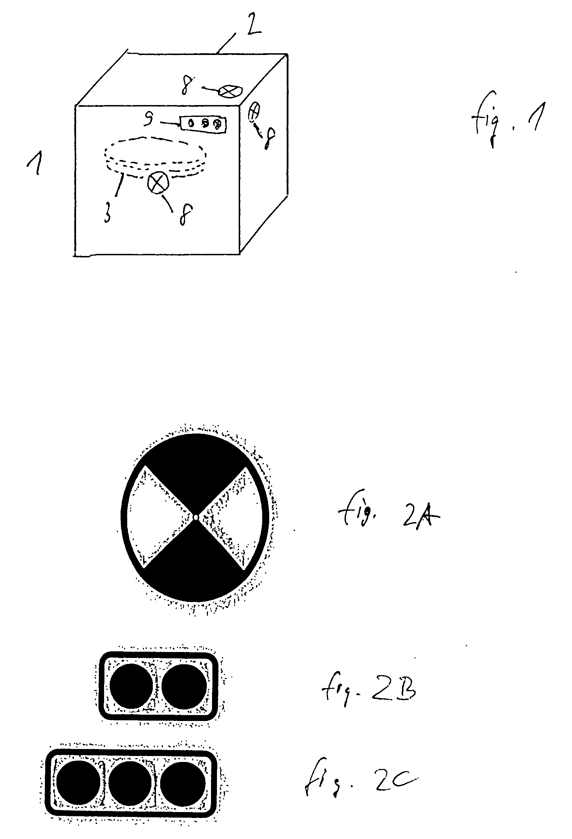

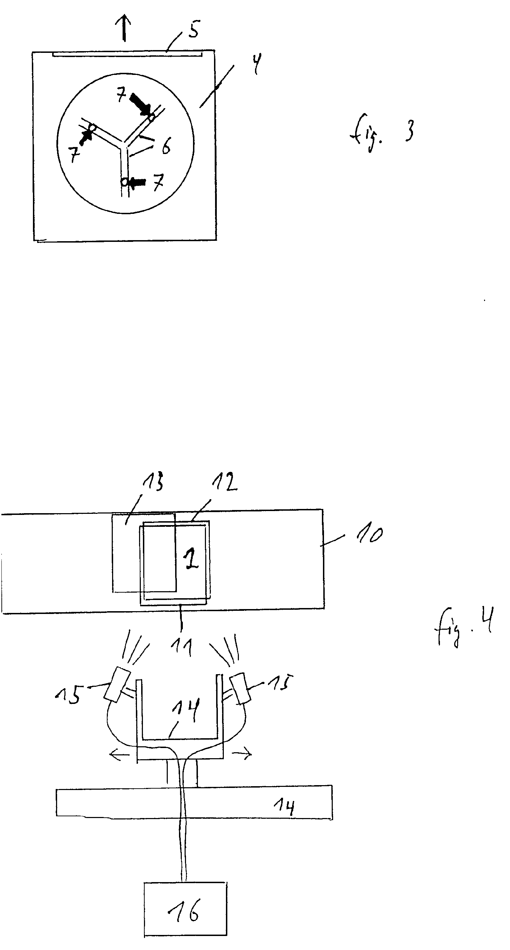

Figure 1 schematically illustrates a FOUP seen from front-right-top side perspective view. The actual, rather complex shape of a FOUP will be familiar to those skilled in the art. The FOUP accommodates a number of semiconductor wafers indicated by dashed lines with reference number 3 in its housing 2. The three surfaces illustrated as well as the left and back side form the cover region enclosing the semiconductor product from at least two directions. Furthermore, the container comprises a support region illustrated in detail in Figure 3.

In Figure 1, each surface has a marking element 8 for marking one respective reference point of the surface. In addition, there may be provided markings 9 for indicating what kind of side of the container is facing the equipment according to the present invention.

Figure 2A shows a marking element for marking one reference point position. It is an optical contrast marking and is formed of a circle surrounding four quarter contrast regions, the regions of equal brightness being located opposed to each other with respect to the center of the circle.

In Figures 2B and 2C, additional markings for characterizing the kind of the surface regarded are proposed for example.

In Figure 3, the bottom side of the FOUP is shown from beneath. The whole bottom plain serves to support the housing of the FOUP when standing on an essentially even ground like a shelf. In addition, in an inner circular region three grooves 6 to engage with cinematic coupling pins 7 indicated by arrows are illustrated. Engagement of members 6 and 7 grants for highly precise docking of the FOUP to the loadport not illustrated.

Reference numeral 5 indicates the load/unload region for loading and/or unloading the semiconductor products, the arrow above indicating the direction in which the FOUP is coupled to the loadport.

Figure 4 illustrates the equipment according to the present invention and its function. It is constructed to handle containers at any positions on other storage locations like shelves 10, for instance. Apart from predefined container positions 11 allowing transport according to prior art, the equipment according to the present invention allows for transport even in case of minor deviations of the actual position 12 from the predefined position 11 as well as in case of non-predefined, that is continuously variable positions 13.

The equipment comprises handling means 14 for transporting the container between a loading device and other locations. According to the invention, the equipment comprises detection means 15 which preferably are optical cameras. They detect the position of the marking elements and are connected to localization means 16 for computing the position of the container of the detected reference point positions. Preferably, the localization means compute the position of the grooves 6, especially of their points of engagement with coupling pins 7 illustrated in Figure 3. The handling means 14, 15 are then controlled to move in a position appropriate for approaching the container and grabbing it.

As a result of the present invention, a database for storing all FOUP support positions of storing locations is no longer required. Instead, the automated equipment according to the invention can derive the relative position of the FOUP to its own location and pick up the FOUP from any location in controlled manner. The marking elements according to the present invention may be combined with barcode labels for FOUP identification, and for their recognition the same optical means may be employed. Preferably, the handling means may be moved to the position comparative to the position of the FOUP corresponding to a certain direction given by the actual orientation of the FOUP. In this way, any positioned FOUP may be grabbed from a certain direction as required in modern wafer handling especially for 300 mm carriers. Details of the equipment as grippers, handling arms, robotics and so on will be apparent to those skilled in the art. Apart from atmospherically isolating FOUPs, also open cassettes for smaller wafer sizes can be handled according to the invention.

## Claims

1. Container (1) for the storage and/or the transport of at least one semiconductor product (3), the container comprising a housing (2) with
- a support region (4) supporting the housing when standing on an essentially even ground,
- a load/unload region (5) for loading and/or unloading the semiconductor product and
- a cover region enclosing the semiconductor product form at least two directions,
wherein the housing comprises second support members (6) positioned at predefined positions of the housing (2) and engageable with first support members (7) forming part of a semiconductor product loading/unloading device,
**characterized in that**
the container comprises marking elements (20) marking reference points of the container, the reference points having predefined positions relative to the second support members (6).

2. Container according to claim 1,
**characterized in that**
the marking elements are providing at least two surfaces.

3. Container according to claim 2,
**characterized in that**
the marking elements are provided at three surfaces.

4. Container according to one of claims 1 to 3,
**characterized in that**
the marking elements are three-dimensional markings.

5. Container according to one of claims 1 to 3,
**characterized that**
the marking elements are optical markings.

6. Container according to claim 5,
**characterized in that**
the optical markings are contrast markings.

7. Container according to one of claims 1 to 6,
**characterized in that**
the markings are reflective.

8. Container according to one of claims 5 to 7,
**characterized in that**
the optical markings are labels attached to the housing. (2).

9. Container according to one of claims 1 to 8,
**characterized in that**
a marking element (8) is identifying a reference point in two directions.

10. Container according to one of claims 1 to 9,
**characterized in that**
the container comprises further optical markings (9) identifying one of a front-, side-, rear- or top side of the container.

11. Container according to one of claims 1 to 10,
**characterized in that**
the second support members (6) are connected to the support region (4).

12. Container according to one of claims 1 to 10,
**characterized that**
the second support members (6) are grooves.

13. Container according to one of claims 1 to 10,
**characterized in that**
the container is a front-opening unified pod (FOUP).

14. Equipment for handling a semiconductor product container (2), the equipment comprising
- handling means (14) for transporting the container (1) between a loading/unloading position of a semiconductor product loading/unloading device and positions at other locations and for positioning the container in the loading/unloading position,
the loading/unloading position being such that first support members (7) forming part of the loading/unloading device engage with second support members (6) forming part of the container (1),
**characterized in that**
the equipment comprises
- detection means (15) for detecting reference point positions of the container and
- localization means (16) for computing the position of the container from the detected reference point positions,
wherein the detection means and the localization means are controlling the equipment to position the container in the loading/unloading position, if
actual positions (12) at the other locations (10) are deviating from predefined positions (11) stored by the equipment and/or if
actual positions (13) at the other locations (10) are non-predefined with view to at least one direction or orientation.

15. Equipment according to claim 14,
**characterized in that**
the detection means (15) are attached to movable handling means (14).

16. Equipment according to claim 14 or 15,
**characterized in that**
the detection means (15) comprise an optical camera.

17. Equipment according to one of claims 14 to 16,
**characterized in that**
a comparative position of the handling means relative to a position of the container is computed.

18. Equipment according to claim 18,
**characterized in that**
the handling means are moved from the comparative position to a position predefined relative to the container and suitable to grab the container.

19. Equipment according to one of claims 14 to 18,
**characterized in that**
the equipment is constructed to transport and position containers of the kind according to one of claims 1 to 13.
